# EUROPÄISCHE PATENTSCHRIFT

(11) **EP 1 320 195 B1**
(45) Veröffentlichungstag und Bekanntmachung des Hinweises auf die Patenterteilung: **01.03.2006**
(21) Anmeldenummer: 02025408.2
(22) Anmeldetag: 14.11.2002
(51) Int. Cl.: H03L 7/187

(54) **Frequenzsynthesizer mit Vorabstimmungseinrichtung**
Frequency synthesizer comprising a pretune arrangement
Synthétiseur de fréquence comprenant un dispositif de pré-accord

(30) Priorität: 11.12.2001 DE 10160627
(43) Veröffentlichungstag der Anmeldung: 18.06.2003
(73) Patentinhaber: Rohde & Schwarz GmbH & Co. KG, 81671 München (DE)
(72) Erfinder: Bös, Peter, 81539 München (DE)
(74) Vertreter: Körfer, Thomas

(56) Entgegenhaltungen:
- US-A- 4 562 410
- US-A- 4 935 706
- US-A- 5 304 956

## Beschreibung

Die Erfindung betrifft einen Frequenzsynthesizer mit einem spannungsgesteuerten Oszillator und einer phasengerasteten Regelschleife sowie einer Vorabstimmungseinrichtung.

Die Verwendung einer Vorabstimmungseinrichtung zum Vorabstimmen einer Eingangsspannung eines spannungsgesteuerten Oszillators eines Frequenzsynthesizers ist zum Beispiel aus der DE 42 22 105 A1 bekannt. Die von einem Mikrowellenoszillator erzeugte Ausgangsfrequenz wird einer Regelschleife zugeführt, welche einen Phasen-/Frequenzdetektor aufweist sowie einem dem Phasen-/Frequenzdetektor nachgeschalteten Schleifenfilter. Dem Phasen-/Frequenzdetektor wird von einer Referenzquelle eine Frequenz vorgegeben. Mit Hilfe einer solchen Regelschleife (PLL; Phase-Locked-Loop) wird die Eingangsspannung des Oszillators so geregelt, daß zwischen der von dem Oszillator erzeugten Frequenz und der Referenzfrequenz keine Phasenverschiebung auftritt. Soll am Ausgang des Oszillators eine andere Frequenz erzeugt werden, so wird die Eingangsspannung des Oszillators über eine Vorabstimmungseinrichtung auf einen neuen Sollwert gesetzt. Die Vorabstimmungseinrichtung kann beispielsweise als Digital-/Analog-Wandler ausgebildet sein über dessen Ausgang der Eingang des Oszillators mit einer neuen Spannung angesteuert wird. Nach erfolgter Vorabstimmung wird der Oszillator wieder der PLL überlassen.

Durch das Trennen der Vorabstimmungseinrichtung von dem Eingang des Oszillators geht dabei die Vorabstimmungsinformation verloren. Bis zum Einrasten des Oszillators auf der gewünschten Zielfrequenz vergeht damit eine vergleichsweise lange Zeit.

Die US 4 935 706 zeigt einen Frequenzsynthesizer mit Vorabstimmmöglichkeit gemäß dem Oberbegriff des Anspruchs 1.

Der Erfindung liegt die Aufgabe zugrunde, einen Frequenzsynthesizer mit einer Vorabstimmungseinrichtung zu schaffen, bei dem eine schnelle und genaue Vorabstimmung der Oszillator-Abstimmgröße möglich ist, ohne dabei die Eigenschaften der phasengerasteten Regelschleife zu verschlechtern.

Die Aufgabe wird durch den erfindungsgemäßen Frequenzsynthesizer mit den Merkmalen des Anspruchs 1 gelöst.

Die Vorabstimmungseinrichtung des erfindungsgemäßen Frequenzsynthesizers umfaßt eine zweite Regelschleife, in die der Schleifenfilter der PLL eingebunden ist. Die Vorabstimmgröße, die von der Vorabstimmungseinrichtung an der Anschlußstelle des Schleifenfilters erzeugt wird, wirkt auf den Integrator der phasengerasteten, ersten Regelschleife. Durch die Einbindung des Integrators und des Phasenkorrekturglieds der phasengerasteten ersten Regelschleife wird nicht nur die Zielgröße auf dem Weg eines aperiodischen Grenzfalls erreicht, sondern auch verhindert, daß nach Umschalten von der Vorabstimmung auf die phasengerastete Regelschleife die Vorabstimmungsinformation verloren geht.

Durch Ausbilden von Schaltelementen an den Schnittstellen der ersten mit der zweiten Regelkreis ist eine Trennung der ersten und zweiten Regelschleife möglich. Wird zwischen der ersten und zweiten Regelschleife umgeschaltet, kann auf diese Art und Weise der Einfluß z.B. des Rauschens der Vorabstimmungseinrichtung während des Betriebs der PLL verhindert werden.

Durch die in den Unteransprüchen aufgeführten Maßnahmen sind vorteilhafte Weiterbildungen des erfindungsgemäßen Frequenzsynthesizers möglich.

Ein weiterer Vorteil liegt in der zuschaltbaren Verbindungsleitung zu dem Phasenkorrekturglied. Die in dem Phasenkorrekturglied vorhandenen Kapazitäten können durch die Verbindung mit dem Integratorausgang während des Vorabstimmungsvorgangs schnell auf ihre Zielwerte gebracht werden. Die zusätzliche Verbindungsleitung kann durch ein Schaltelement vom Integratorausgang getrennt werden. Die zusätzliche Verbindungsleitung konfiguriert das Phasenkorrekturglied mit Tiefpaß bei geschlossenem Schaltelement in einen Tiefpaß 1. Ordnung um und ist zum schnellen Umladen der Kapazitäten mit einem angepaßten Widerstand versehen. Das Phasenkorrekturglied des Schleifenfilters kann im Hinblick auf z.B. das Rauschverhalten und das Einschwingverhalten der PLL optimiert werden.

Ein Ausführungsbeispiel des erfindungsgemäßen Frequenzsynthesizers ist in der Zeichnung dargestellt und in der anschließenden Beschreibung erläutert. Es zeigen:
- Fig. 1: ein Blockschaltbild eines erfindungsgemäßen Frequenzsynthesizers; und
- Fig. 2: eine beispielhafte Darstellung eines zeitlichen Verlaufs der Oszillator-Abstimmgröße.

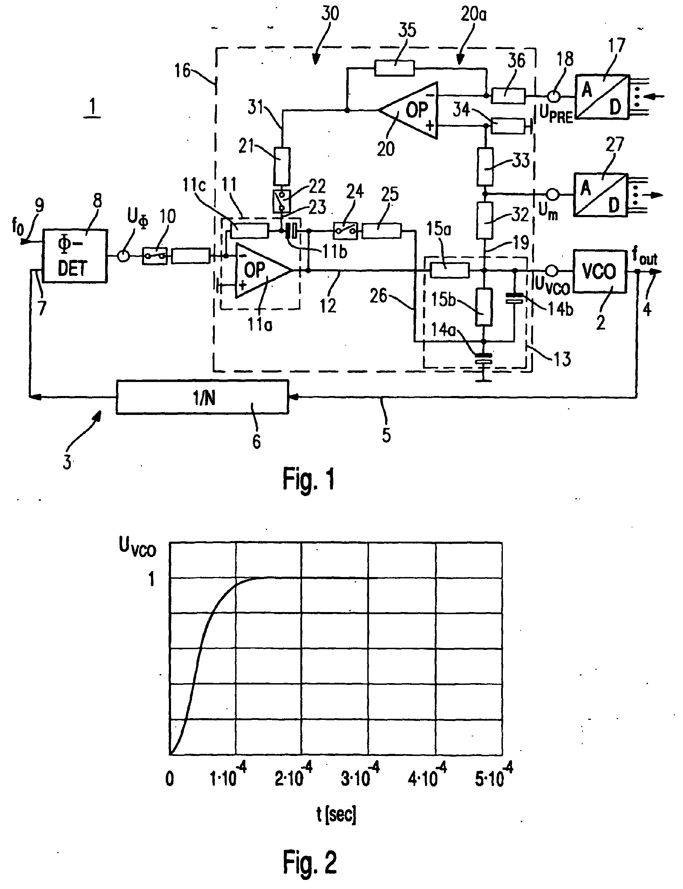

In Fig. 1 ist der Aufbau eines erfindungsgemäßen Frequenzsynthesizers 1 anhand eines Blockschaltbilds übersichtsweise dargestellt. Zur Erzeugung einer gewünschten Ausgangsfrequenz des Frequenzsynthesizers 1 ist ein spannungsgesteuerter Oszillator (VCO) 2 vorgesehen, der in Abhängigkeit von einer Oszillator-Abstimmgröße, im dargestellten Ausführungsbeispiel einer Oszillator Abstimmspannung U_{VCO}, steuerbar ist. Die von dem Oszillator 2 erzeugte Frequenz ist über eine phasengerastete erste Regelschleife 3 auf das Eingangssignal U_{VCO} des spannungsgeregelten Oszillators 2 rückgekoppelt. Das an einem Synthesizerausgang 4 erzeugte Signal mit der Frequenz fₒᵤₜ wird über eine Rückführleitung 5 einem Teiler 6 zugeführt. Der Ausgang des Teilers 6 ist mit einem ersten Eingang 7 eines Phasendetektors 8 verbunden. Einem zweiten Eingang 9 des Phasendetektors 8 wird eine Referenzfrequenz f₀ einer Referenzfrequenzquelle als Führungsgröße der PLL zugeführt. Als Ausgangswert liefert der Phasendetektor 8 ein Spannungssignal, dessen Mittelwert U_{φ} abschnittsweise proportional zu der Phasenverschiebung zwischen dem Signal des ersten Eingangs 7 und des zweiten Eingangs 9 ist. Der Ausgang des Phasendetektors 8 ist mit einem Eingang eines Integrators 11 verbunden, wenn ein erstes Schaltelement 10 geschlossen ist. Der Integrator 11 besteht im Ausführungsbeispiel aus einem Operationsverstärker 11a, welcher über einen Kondensator 11b und einen Widerstand 11c dynamisch gegengekoppelt ist. Der Ausgang des Operationsverstärkers 11a ist über ein Phasenkorrekturglied mit Tiefpaß 13 mit dem Oszillator 2 verbunden. Die Verstärkung des Integrators 11 hat in der ersten Regelschleife 3 neben dem integralen Teil auch einen proportionalen Teil, bezüglich einer Anschlußstelle 23 dagegen nur einen integralen Anteil.

Im dargestellten Ausführungsbeispiel umfaßt das Phasenkorrekturglied mit Tiefpaß 13 zwei Kondensatoren 14a und 14b sowie zwei Widerstände 15a und 15b. Der in den Signalpfad geschaltete Widerstand 15a bildet zusammen mit den in Serie gegen Masse geschalteten Kondensatoren 14b und 14a den Tiefpaß, wobei dem Kondensator 14b der Widerstand 15b parallel geschaltet ist. Die Dimensionierung der Bauteile des Phasenkorrekturglieds mit Tiefpaß 13 erfolgt so, daß die beschriebene, an sich bekannte erste Regelschleife 3 im Hinblick auf ihr Rauschverhalten und einen kurzen Einschwingvorgang optimiert ist.

Bevor der Aufbau und die Funktionsweise der Vorabstimmungseinrichtung 30 erläutert werden, soll zum besseren Verständnis die Funktion der ersten Regelschleife 3 kurz dargestellt werden. Sind die an dem ersten Eingang 7 und dem zweiten Eingang 9 anliegenden Signale in Phase, so wird durch den Phasendetektor 8 als mittlere Ausgangsspannung U_{φ} Null Volt ausgegeben. Am Ausgang des Operationsverstärkers 11a liegt damit eine konstante Spannung an, die über die Verbindungsleitung 12 und das Phasenkorrekturglied mit Tiefpaß 13 als Oszillator-Abstimmspannung U_{VCO} dem Oszillator 2 zugeführt wird. Unterscheiden sich dagegen die beiden Phasen, welche an dem ersten Eingang 7 und dem zweiten Eingang 9 des Phasendetektors 8 miteinander verglichen werden, so gibt der Phasendetektor 8 eine mittlere Spannung U_{φ} aus, welche von Null verschieden ist. Solange die mittlere Spannung des Phasendetektors 8 ungleich Null ist, wird durch den Integrator 11 die Oszillator-Abstimmspannung U_{VCO} soweit verändert, bis die Phasenverschiebung des Signals an dem ersten Eingang 7 und dem zweiten Eingang 9 verschwindet. Damit wird die Ausgangsspannung des Phasendetektors 8 U_{φ} ebenfalls. Null. Der Oszillator 2 kann damit entsprechend den möglichen Teilungsfaktoren 1/N des Teilers 6 bei (nicht notwendigerweise ganzzahligen) Vielfachen der an dem zweiten Eingang 9 anliegenden Referenzfrequenz f₀ als Führungsgröße der ersten Regelschleife 3 betrieben werden.

Bei Vorgabe einer neuen Zielfrequenz f'ₒᵤₜ für den Oszillator 2 ist ein schnelles Abstimmen der Oszillator-Abstimmspannung U_{VCO} erforderlich, wozu erfindungsgemäß eine Vorabstimmungseinrichtung 30 vorgesehen ist. Die Vorabstimmungseinrichtung 30 ist als zweite Regelschleife 16 ausgebildet, mit der Oszillator-Abstimmspannung U_{VCO} als Regelgröße. Die zweite Regelschleife 16 weist einen Eingang 18 sowie einen Anschlußpunkt 19 auf. An dem Eingang 18 wird durch einen D/A-Wandler 17 eine Führungsgröße Uₚᵣₑ zugeführt, wobei die Führungsgröße U_{PRE} z.B. durch einen nicht dargestellten Prozessor einem D/A-Wandler 17 als Digitalwort vorgegeben ist und von dem Prozessor die zeitliche Steuerung beim Umschalten zwischen der ersten und zweiten Regelschleife 3 und 16 durchgeführt wird. Der Eingang 18 und der Anschlußpunkt 19 sind mit den beiden Eingängen des Operationsverstärkers 20 verbunden, der durch die Beschaltung mit den Widerständen 32, 33, 34, 35 und 36 zu einem Differenzverstärker 20a ausgebildet wird. Über eine Anschlußstelle 23 ist der Differenzverstärker 20a der Vorabstimmungseinrichtung 30 mit dem Integrator 11 verbunden, so daß der Schleifenfilter der ersten Regelschleife 3 in die zweite Regelschleife 16 eingebunden ist. Zwischen der Anschlußstelle 23 der Vorabstimmungseinrichtung 30 und dem Ausgang des Differenzverstärkers 20a ist ein erster Abstimmwiderstand 21 sowie ein zweites Schaltelement 22 angeordnet. Bei geschlossenem zweiten Schaltelement 22 wird der Ausgang des Differenzvertärkers 20a an der Anschlußstelle 23 der Vorabstimmeinrichtung 30 zwischen dem Kondensator 11b und dem Widerstand 11c mit dem Schleifenfilter verbunden.

Der Ausgang des Integrators 11 ist über eine zusätzliche Verbindungsleitung 26 so mit dem Pasenkorrekturglied mit Tiefpaß 13 verbunden, daß der die beiden Kondensatoren 14a und 14b verbindende Schaltpunkt unter Umgehung der beiden Widerstände 15a und 15b des Phasenkorrekturglied mit Tiefpaß 13 mit dem Ausgang des Integrators 11 direkt verbindbar sind. Die zusätzliche Verbindungsleitung 26 ist über ein drittes Schaltelement 24 trennbar mit der Verbindungsleitung 12 bzw. dem Ausgang des Integrators 11 verbunden, wobei dem dritten Schaltelement 24 ein zweiter Abstimmwiderstand 25 nachgeschaltet ist.

Zur Einstellung einer neuen Frequenz f'ₒᵤₜ des Frequenzsynthesizers 1 wird die erste Regelschleife 3 durch Öffnen des ersten Schaltelements 10 außer Betrieb gesetzt. Das zweite Schaltelement 22 und das dritte Schaltelement 24 werden geschlossen. Damit ist die Regelschleife 16 der Vorabstimmungseinrichtung 30 in Betrieb. An dem Eingang 18 der Vorabstimmungseinrichtung 30 wird durch den Digital/Analog-Wandler 17 eine der Zielfrequenz entsprechende Spannung als Führungsgröße Uₚᵣₑ erzeugt. An dem Anschlußpunkt 19 der Vorabstimmungseinrichtung 30 liegt ein Teil der Oszillator-Abstimmspannung U_{VCO} als Vergleichswert an, welche der zuvor eingestellten Frequenzwert fₒᵤₜ des Oszillators 2 entspricht. Ein Teil der Oszillator-Abstimmspannung U_{VCO} wird über ein als Spannungsteiler wirkendes Widerstandsnetzwerk, das aus den Widerständen 32, 33 und 34 besteht, dem +Eingang des Operationsverstärkers 20 zugeführt, während die Vorabstimmgröße Uₚᵣₑ über den Widerstand 36 dem -Eingang des Operationsverstärkers 20 zugeführt wird. Aufgrund der sich daraus ergebenden Differenz an den beiden Eingängen des Differenzverstärkers 20a wird von dem Differenzverstärker 20a über die Anschlußstelle 23 die Eingangsgröße des Integrators 11 beeinflußt.

Ist am Ende des Vorabstimmvorgangs die Oszillator-Abtimmspannung U_{VCO} gleich dem Sollwert, so wird die Spannungdifferenz an den Eingängen des Differenzverstärkers 20a Null. Am Ausgang des Integrators 11 liegt damit ein konstanter Wert für die Oszillator-Abstimmspannung U_{VCO} an.

Während des Vorabstimmungsvorgangs ist die Verbindungsleitung 12 über das dritte Schaltelement 24 und einen nachgeschalteten zweiten Abstimmwiderstand 25 mit den Kondensatoren 14a und 14b des Phasenkorrekturglieds mit Tiefpaß 13 verbunden und konfiguriert diesen zu einem Tiefpaß 1. Ordnung um. Die charakteristische Kreisfrequenz und der Dämpfungsfaktor der Übertragungsfunktion der Vorabstimmungseinrichtung hängen von dem ersten und zweiten Abstimmwiderstand 21 und 25 ab. Damit läßt sich das zeitliche Verhalten durch von der ersten Regelschleife unabhängige Bauteile einstellen. Der anzustrebende und auch einstellbare aperiodische Grenzfall des Übergangsverhaltens von U_{VCO} ermöglicht also während der Vorabstimmungsphase ein schnelles Umladen der Kapazitäten 11b, 14a und 14b auf ihre Werte für einen neuen Zielwert von Uₚᵣₑ.

Am Ende eines Vorabstimmungsvorgangs sind die Kapazitäten 11b, 14a und 14b bereits mit ihren Werten für einen Zielwert von Uₚᵣₑ geladen, so daß bei einem erneuten Umschalten der drei Schaltelemente 10, 22 und 24 lediglich eine geringe Schwankung der Oszillator-Abstimmspannung U_{VCO} durch einen Nachladevorgang der Kapazitäten 11b, 14a und 14b aufgrund. von Ungenauigkeiten der Zielwerte von Uₚᵣₑ stattfindet. Wird also das erste Schaltelement 10 geschlossen sowie das zweite und dritte Schaltelement 22 bzw. 24 geöffnet, ist die Vorabstimmungseinrichtung 30 abgetrennt und die erste Regelschleife 3 wieder in Betrieb. An die Vorabstimmungsphase schließt sich nach dem Umschalten der Schaltelemente 10, 22 und 24 der Einschwingvorgang der ersten Regelschleife 3 an, in dem von der ersten Regelschleife 3 wegen der Ungenauigkeiten der Zielwerte von Uₚᵣₑ und somit auch der Oszillator-Abstimmspannung U_{VCO} und damit der Ausgangsfrequenz fₒᵤₜ ein geringer Frequenzversatz bei einer beliebigen Anfangsphase korrigiert wird, wobei die zeitliche Abfolge des Betätigens der Schaltelemente 10, 22 und 24 durch den bereits genannten nicht dargestellten Prozessor erfolgt.

Zur Überwachung des zeitlichen Verlaufs der Oszillator-Abstimmspannung U_{VCO} kann an dem eingangsseitig in der Vorabstimmungseinrichtung 16 vorgesehenen Widerstandsnetzwerk 32-34 ein Analog/Digital-Wandler 27 angeschlossen sein, der die Meßspannung Uₘ erfaßt und so das Erkennen einer temperatur- und alterungsbedingten Änderung der Oszillatorkennlinie einfach ermöglicht. Durch die genaue Kenntnis der Oszillatorkennlinie läßt sich der Restfehler der Oszillator-Abstimmspannung U_{VCO} am Ende des Vorabstimmvorgangs minimieren. Der Restfehler soll dabei im Hinblick auf eine schnelle Abstimmung auf die Zielfrequenz so klein sein, daß die erste Regelschleife 3 im linearen Bereich des Phasendetektors 8 arbeitet. Durch das vollständige Entkoppeln der Vorabstimmungseinrichtung 30 während des Betriebes des Frequenzsynthesizers 1 von der ersten Regelschleife 3 wird ein Einfluß von Störgrößen, wie z.B. des Rauschens des Differenzverstärkers 20 und vor allem eines schnellen D/A-Wandlers 17 vollständig ausgeschlossen. Als Schaltelemente 10, 22, 24 werden als niederohmige, ladungsinjektionsarme Schaltelemente beispielsweise Feldeffekttransistoren verwendet.

In Fig. 2 ist beispielhaft ein zeitlicher Verlauf der Oszillator-Abstimmspannung U_{VCO} dargestellt, wobei die Oszillator-Abstimmspannung U_{VCO} auf die Oszillator-Abstimmspannung U_{VCO} der Zielfrequenz normiert ist. Von der gesamten Einschwingzeit des Synthesizers von ca. 1ms werden nur 0.17ms für die Vorabstimmung benötigt, was der Forderung nach einer Dauer für den Vorabstimmungsvorgang entspricht, die im Vergleich zu der Einschwingdauer der PLL kurz ist. Die Regelbandbreite der PLL ist dabei, für optimales Phasenrauschen, mit 2.5kHz festgelegt.

## Patentansprüche

1. Frequenzsynthesizer (1) mit
einem über eine Oszillator-Abstimmgröße (U_{VCO}) gesteuerten Oszillator (2),
einer mittels der Oszillator-Abstimmgröße (U_{VCO}) eine Ausgangsphase regelnden phasengerasteten ersten Regelschleife (3), die einen Phasendetektor (8) und einen mit dessen Ausgang verbundenen Integrator (11) umfaßt, und einer Vorabstimmungseinrichtung (30) zur Vorabstimmung der Oszillator-Abstimmgröße (U_{VCO}) in Abhängigkeit von einer Führungsgröße (Uₚᵣₑ) ,
wobei die Vorabstimmungseinrichtung (30) eine zweite Regelschleife (16) umfaßt, wobei über einen Eingang (18) einem Soll-Istwert-Vergleicher (20a) der Vorabstimmungseinrichtung (30) die Führungsgröße (Uₚᵣₑ) zugeführt ist und über einen Anschlußpunkt (19) dem Soll-Istwert-Vergleicher (20a) der Vorabstimmungseinrichtung (30) die Oszillator-Abstimmgröße (U_{VCO}) zugeführt ist, eine Anschlußstelle (23) der Vorabstimmungseinrichtung (30) mit dem Integrator (11) verbunden ist und die Vorabstimmungseinrichtung (30) an ihrer Anschlußstelle (23) eine Vorabstimmgröße erzeugt, die von der Führungsgröße (Uₚᵣₑ) und der Oszillator Abstimmgröße (U_{VCO}) abhängig ist,
**dadurch gekennzeichnet,**
**daß** der Ausgang des Phasendetektors (8) und die Anschlußstelle (23) der Vorabstimmungseinrichtung (30) mittels eines ersten Schaltelements (10) und mittels eines zweiten Schaltelements (22) wechselweise trennbar mit dem Integrator (11) verbindbar ist.

2. Frequenzsynthesizer nach Anspruch 1,
**dadurch gekennzeichnet,**
**daß** in der Verbindungsleitung (12) zwischen dem Integrator (11) und dem Oszillator (2) ein Phasenkorrekturglied mit Tiefpaß (13) angeordnet ist, dessen zumindest ein kapazitives Bauelement (14a, 14b) über eine zusätzliche schaltbare Verbindungsleitung (26) mit dem Ausgang des Integrators (11) mittels eines dritten Schaltelements (24) verbindbar ist und das Phasenkorrekturglied mit Tiefpaß (13) in einen Tiefpaß 1. Ordnung umkonfigurierbar ist.

3. Frequenzsynthesizer nach Anspruch 2
**dadurch gekennzeichnet,**
**daß** das zeitliche Verhalten der Vorabstimmungseinrichtung (30) durch einen in der Verbindungsleitung (26) vorgesehenen Abstimmwiderstand (25) einstellbar ist.

4. Frequenzsynthesizer nach Anspruch 3,
**dadurch gekennzeichnet,**
**daß** das zeitliche Verhalten der Vorabstimmungseinrichtung (30) durch einen in einer Ausgangsleitung (31) der Vorabstimmungseinrichtung (30) vorgesehenen weiteren Abstimmwiderstand (21) einstellbar ist.

5. Frequenzsynthesizer nach Anspruch 1,
**dadurch gekennzeichnet,**
**daß** die Schaltelemente (10, 22, 24) als Feldeffekttransistoren ausgebildet sind.

6. Frequenzsynthesizer nach einem der Ansprüche 1 bis 5,
**dadurch gekennzeichnet,**
**daß** die Führungsgröße (Uₚᵣₑ) eine mittels eines Digital/Analog-Wandlers (17) vorgebbare Spannung ist.

7. Frequenzsynthesizer nach einem der Ansprüche 1 bis 6,
**dadurch gekennzeichnet,**
**daß** zur Ausgabe der Oszillator-Abstimmgröße (U_{VCO}) ein Analog/Digital-Wandler (27) über ein Widerstandsnetzwert (32, 33, 34) der Vorabstimmungseinrichtung (30) mit der Oszillator-Abstimmgröße (U_{VCO}) verbunden ist.

## Revendications

1. Synthétiseur de fréquence (1) comprenant les éléments suivants
un oscillateur (2) commandé par une grandeur d'accord d'oscillateur (U_{VCO}) .
une première boucle de réglage (3) enclenchée par phase et réglant une phase de sortie au moyen de la grandeur d'accord d'oscillateur (U_{VCO}), qui comprend un détecteur de phase (8) et un intégrateur (11) relié à sa sortie, et un dispositif de pré-accord (30) pour le pré-accord de la grandeur d'accord d'oscillateur (U_{VCO}) en fonction d'une grandeur de guidage (Uₚᵣₑ) ,
le dispositif de pré-accord (30) comprenant une seconde boucle de réglage (16), la grandeur de guidage (Uₚᵣₑ) étant amenée au moyen d'une entrée (18) à un comparateur valeur prescrite-valeur réelle (20a) du dispositif de pré-accord (30) et la grandeur d'accord d'oscillateur (U_{VCO}) étant amenée par un point de raccordement (19) au comparateur valeur prescrite-valeur réelle (20a) du dispositif de pré-accord (30), un point de raccordement (23) du dispositif de pré-accord (30) étant relié à l'intégrateur (11) et le dispositif de pré-accord (30) générant sur son point de raccordement (23) une grandeur de pré-accord qui est dépendante de la grandeur de guidage (Uₚᵣₑ) et de la grandeur d'accord d'oscillateur (U_{VCO}) ,
**caractérisé en ce que**
la sortie du détecteur de phase (8) et le point de raccordement (23) du dispositif de pré-accord (30) peuvent être reliés alternativement de façon séparable à l'intégrateur (11) au moyen d'un premier élément de commutation (10) et au moyen d'un second élément de commutation (22).

2. Synthétiseur de fréquence selon la revendication 1,
**caractérisé en ce que**
un élément de correction de phase avec filtre passe-bas (13), dont au moins un composant (14a, 14b) capacitif peut être relié au moyen d'une ligne de liaison (26) commutable supplémentaire à la sortie de l'intégrateur (11) au moyen d'un troisième élément de commutation (24), est disposé dans la ligne de liaison (12) entre l'intégrateur (11) et l'oscillateur (2) et l'élément de correction de phase avec filtre passe-bas (13) peut être configuré en un filtre passe-bas de premier ordre.

3. Synthétiseur de fréquence selon la revendication 2,
**caractérisé en ce que**
le comportement dans le temps du dispositif de pré-accord (30) peut être réglé par une résistance d'accord (25) prévue dans la ligne de liaison (26).

4. Synthétiseur de fréquence selon la revendication 3,
**caractérisé en ce que**
le comportement dans le temps du dispositif de pré-accord (30) peut être réglé par une autre résistance d'accord (21) prévue dans une ligne de sortie (31) du dispositif de pré-accord (30).

5. Synthétiseur de fréquence selon la revendication 1,
**caractérisé en ce que**
les éléments de commutation (10, 22, 24) sont conçus comme des transistors à effet de champ.

6. Synthétiseur de fréquence selon l'une quelconque des revendications 1 à 5,
**caractérisé en ce que**
la grandeur de guidage (Uₚᵣₑ) est une tension prédéfinissable au moyen d'un convertisseur numérique/analogique (17).

7. Synthétiseur de fréquence selon l'une quelconque des revendications 1 à 6,
**caractérisé en ce que**,
pour la sortie de la grandeur d'accord d'oscillateur (U_{VCO}), un convertisseur analogique/numérique (27) peut être relié au moyen d'une valeur de réseau de résistance (32, 33, 34) du dispositif de pré-accord (30) à la grandeur d'accord d'oscillateur (U_{VCO}).

## Claims

1. Frequency synthesiser (1) comprising an oscillator (2) controlled via an oscillator-tuning parameter (U_{VCO}),
a phase-locked, first control loop (3), which controls an output phase by means of the oscillator-tuning parameter (U_{VCO}), and which comprises a phase detector (8) and an integrator (11) connected to the output of the latter, and a pre-tuning device (30) for pre-tuning the oscillator-tuning parameter (U_{VCO}) dependent upon a guide parameter (Uₚᵣₑ),
wherein the pre-tuning device (30) comprises a second control loop (16), wherein the guide parameter (Uₚᵣₑ) is supplied via an input (18) to a setpoint-actual-value comparator (20a) of the pre-tuning device (30), and the oscillator-tuning parameter (Uvco) is supplied via a connecting point (19) to the setpoint-actual-value comparator (20a) of the pre-tuning device (30), wherein a connecting position (23) of the pre-tuning device (30) is connected to the integrator (11), and the pre-tuning device (30) generates at its connecting position (23) a tuning parameter, which is dependent upon the guide parameter (Uₚᵣₑ) and the oscillator-tuning parameter (U_{VCO}),
**characterised in that**
the output of the phase detector (8) and the connecting position (23) of the pre-tuning device (30) can be connected to the integrator alternately in a separable manner (11) by means of a first switching element (10) and by means of a second switching element (22).

2. Frequency synthesiser according to claim 1,
**characterised in that**,
a phase-correction element with low-pass (13), of which the at least one capacitive component (14a, 14b) can be connected via an additional, switchable connecting line (26) to the output of the integrator (11) by means of a third switching element (24), is disposed in the connecting line (12) between the integrator (11) and the oscillator (2), and that the phase-correction element with low pass filter (13) can be reconfigured into a first-order low pass filter.

3. Frequency synthesiser according to claim 2,
**characterised in that**
the time performance of the pre-tuning device (30) can be adjusted via a tuning resistor (25) provided in the connecting line (26).

4. Frequency synthesiser according to claim 3,
**characterised in that**
the time performance of the pre-tuning device (30) can be adjusted via a further tuning resistor (21) provided in an output line (31) of the pre-tuning device (30).

5. Frequency synthesiser according to claim 1,
**characterised in that**
the switching elements (10, 22, 24) are designed as field-effect transistors.

6. Frequency synthesiser according to any one of claims 1 to 5,
**characterised in that**
the guide parameter (Uₚᵣₑ) is a voltage specifiable by means of an analog-to-digital converter (17).

7. Frequency synthesiser according to any one of claims 1 to 6,
**characterised in that**,
for the output of the oscillator-tuning parameter (U_{VCO}), an analog-to-digital converter (27) is connected via a resistor network (32, 33, 34) to the pre-tuning device (30) with the oscillator-tuning parameter (U_{VCO}).
